# EUROPÄISCHE PATENTSCHRIFT

(11) **EP 1 112 673 B1**
(45) Veröffentlichungstag und Bekanntmachung des Hinweises auf die Patenterteilung: **12.01.2005**
(21) Anmeldenummer: 99944561.2
(22) Anmeldetag: 31.08.1999
(51) Int. Cl.: H05K 1/09

(54) **LEITERBAHNEN AUS POLYALKYLENDIOXYTHIOPHEN**
PRINTED CONDUCTORS MADE OF POLYALKYLENE DIOXYTHIOPHENE
CIRCUITS IMPRIMES EN POLYALKYLENDIOXYTHIOPHENE

(30) Priorität: 12.09.1998 DE 19841804
(43) Veröffentlichungstag der Anmeldung: 04.07.2001
(73) Patentinhaber: Bayer Aktiengesellschaft, 51368 Leverkusen (DE)
(72) Erfinder: HEUER, Helmut-Werner, D-47829 Krefeld (DE); JONAS, Friedrich, D-52066 Aachen (DE); WEHRMANN, Rolf, D-47800 Krefeld (DE); PIELARTZIK, Harald, D-47800 Krefeld (DE)
(86) Internationale Anmeldenummer: PCT/EP1999/006385
(87) Internationale Veröffentlichungsnummer: WO 2000/016595

(56) Entgegenhaltungen:
- EP-A- 0 615 257
- US-A- 5 447 824

## Beschreibung

Die Erfindung betrifft ein Verfahren zur Beschichtung von Substraten, wie z.B. Papier oder Kunstoff-Folien mit offenen, elektrisch leitfähigen Strukturen durch Tintenstrahldrucken oder mit Hilfe von X, Y-Plottern. Zum Bedrucken wird eine Polymerlösung aus wasserdispergierbaren Polyalkylendioxythiophenen verwendet.

Allgemein bekannte Substrate mit einer elektrisch leitfähigen Struktur sind Platinen für elektrische Schaltungen. Platinen bestehen aus einem starren oder flexiblen Kunststoffsubstrat, auf das Leiterbahnen aus Kupfer aufgebracht wurden. Das Aufbringen der Kupferbahnen erfolgt durch Fotodruck oder durch Siebdruck.

Beim Photodruck nach dem Positiv-Verfahren wird zunächst ganzflächig Kupfer auf das Substrat aufgebracht. Auf das Kupfer wird ganzflächig Photoresist verteilt. Das Photoresist wird durch eine Maske an den Stellen belichtet, an denen Leiterbahnen verlaufen sollen. Durch die Belichtung härtet das Photoresist aus. Bei der anschließenden Entwicklung werden die nicht ausgehärteten Photoresist-Bereiche entfernt. Das nunmehr freiliegende Kupfer wird im nächsten Schritt weggeätzt. Nach Entfernen des ausgehärteten Photoresists (Strippen) sind nur noch die gewünschten Kupfer-Leiterbahnen vorhanden.

Beim Siebdruck Verfahren wird auf ein ganzflächig mit Kupfer bedecktes Substrat ein Bild der gewünschten Leiterstruktur als Ätzschutz aufgedruckt. Beim anschließenden Ätzen wird das Kupfer zwischen den gewünschten Leiterbahnen weggeätzt und anschließend der Ätzschutz entfernt.

Bei der direkten Beschichtung von nichtleitenden Trägem mit einer Metallauflage kann es zu Problemen bei der Haftung des Metalls auf dem Träger kommen. In diesem Fall kann eine Siebdruckpaste auf Basis eines elektrisch leitfähigen Polymers eine gute Verbidnung zwischen Träger und Auflage herstellen. Die Leiterbahnstrukturen aus dem Polymer werden z.B. durch Siebdruck auf ein nicht leitendes Substrat aufgedruckt und anschließend chemisch verkupfert (DE 36 25 587, DE 36 27 256).

Die Verwendung von elektrisch leitfähigen Polymeren als elektrisch leitfähige Struktur auf Substraten ist auch im Zusammenhang mit Elektrolumineszenz-Anzeigen auf Polymerbasis bekannt (Science, 17 October 1997, p. 383). Zum Aufbringen der elektrisch leitfähigen Polymere wurde eine Lösung aus den Polymeren in die Patrone eines Tintenstrahldruckers gefüllt und mit dem Drucker auf das Substrat gedruckt. Ein großes Problem bei diesem Verfahren lag darin, daß das organische Lösungsmittel für die Polymere, in der Regel ein halogenierter Kohlenwasserstoff oder Tetrahydrofuran, den Kunststoff der Druckerpatrone angriff durch Anlösen oder Anquellen.

Um diesen Nachteil zu umgehen wurden von Y. Yang und J. Bharathan (Science, Vol. 279, 20 February 1998) ein wasserlösliches Polymer aus der Verbindungsklasse der Polythiophene verwendet. Durch diese wasserlöslichen Polymere werden die Druckerpatronen nicht angegriffen. Da Strukturen von wasserlösliche Polymere sich auch durch die Luftfeuchtigkeit verändern, sind sie nur geeignet, wenn sie nach Entfernen der Wasseranteile in einem Temperschritt keinen weiteren Kontakt zu Wasser haben. Bei Lumineszenz-Anzeigen auf Polymer-Basis stellt diese Bedingung kein Problem dar, da leitfähigen Strukturen nach dem Entfernen des Wassers und nach einer eventuellen weiteren Bearbeitung unter Inertbedingungen komplett luftdicht verkapselt werden. Für offene, das heißt der Umgebungsluft ausgesetzte, Leiterbahnstrukturen sind die wasserlöslichen Polythiophene jedoch nicht geeignet.

Aufgabe der Erfindung war es ein Verfahren zur Herstellung von offenen elektrisch leitfähigen Strukturen auf Substraten zu finden, das einfacher und schneller durchzuführen ist, als die bekannten Verfahren der Strukturierung mit Kupfer-Leiterbahnen und zu stabilen Leiterbahnstrukturen unter Normalbedingungen führt.

Die erfindungsgemäße Aufgabe wird dadurch gelöst, daß die leitfähigen Strukturen mit einem Tintenstrahldrucker oder X, Y-Plotter, in deren Patrone sich eine wässrige Dispersion von Polyalkylendioxythiophenen mit einem geeigneten Polyanion als Gegenanion befindet, auf ein Substrat gedruckt werden.

Als Substrat kann Papier oder Kunststoffolie verwendet werden.

Die Polyalkylendioxythiophene sind kationisch geladen und aus Struktureinheiten der Formel (I) 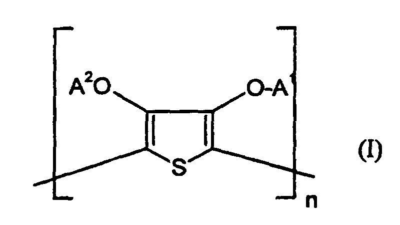 aufgebaut, in der
- A¹ und A²: unabhängig voneinander für gegebenenfalls substituiertes (C₁-C₄)-Alkyl stehen oder zusammen gegebenenfalls substituiertes (C₁-C₄)-Alkylen bilden, und
- n: für eine ganze Zahl von 2 bis 10 000 vorzugsweise 5 bis 5 000 steht,
in Gegenwart von Polyanionen.

Bevorzugte kationische Polyalkylendioxythiophene sind aus Struktureinheiten der Formel (Ia) oder (Ib) aufgebaut 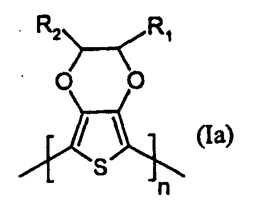 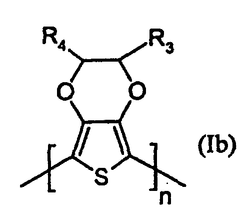 worin
- R₁ und R₂: unabhängig voneinander für Wasserstoff, gegebenenfalls substituiertes (C₁-C₁₈)-Alkyl, vorzugsweise (C₁₋C₁₀)-, insbesondere (C₁-C₆)-Alkyl, (C₂-C₁₂)-Alkenyl, vorzugsweise (C₂-C₈)-Alkenyl, (C₃-C₇)-Cycloalkyl, vorzugsweise Cyclopentyl, Cyclohexyl, (C₇-C₁₅)-Aralkyl, vorzugsweise Phenyl-(C₁-C₄)-alkyl, (C₆-C₁₀)-Aryl, vorzugsweise Phenyl, Naphthyl, (C₁-C₁₈)-Alkyloxy, vorzugsweise (C₁-C₁₀)-Alkyloxy, beispielsweise Methoxy, Ethoxy, n- oder iso-Propoxy, oder (C₂-C₁₈)-Alkyloxyester steht und
- R₃, R₄: unabhängig voneinander für Wasserstoff, aber nicht beide gleichzeitig, mit mindestens einer Sulfonatgruppe substituiertes (C₁-C₁₈)-Alkyl, vorzugsweise (C₁-C₁₀)-, insbesondere (C₁-C₆)-Alkyl, (C₂-C₁₂)-Alkenyl, vorzugsweise (C₂-C₈)-Alkenyl, (C₃-C₇)-Cycloalkyl, vorzugsweise Cyclopentyl, Cyclohexyl, (C₇-C₁₅)-Aralkyl, vorzugsweise Phenyl-(C₁-C₄)-alkyl, (C₆-C₁₀)-Aryl, vorzugsweise Phenyl, Naphthyl, (C₁-C₁₈)-Alkyloxy, vorzugweise (C₁-C₁₀)-Alkyloxy, beispielsweise Methoxy, Ethoxy, n- oder iso-Propoxy oder (C₂-C₁₈)-Alkyloxyester steht.
- n: für eine Zahl von 2 bis 10 000, vorzugsweise 5 bis 5 000 steht.

Besonders bevorzugt sind kationische oder neutrale Polyalkylendioxythiophene der Formeln (Ia-1) und/oder Ib-1) 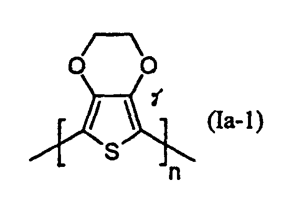 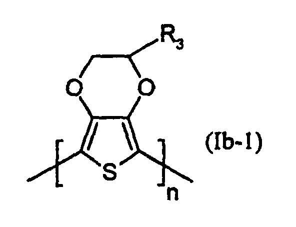 worin
- R₃: die obengenannte Bedeutung hat und
- n: für eine ganze Zahl von 2 bis 10 000, vorzugsweise 5 bis 5 000 steht.

Als Polyanionen dienen die Anionen von polymeren Carbonsäuren, wie Polyacrylsäuren, Polymethacrylsäuren, oder Polymaleinsäuren und polymeren Sulfonsäuren, wie Polystyrolsulfonsäuren und Polyvinylsulfonsäuren. Diese Polycarbon- und -sulfonsäuren können auch Copolymere von Vinylcarbon- und Vinylsulfonsäuren mit anderen polymerisierbaren Monomeren, wie Acrylsäureestern und Styrol sein.

Besonders bevorzugt ist das Anion der Polystyrolsulfonsäure (PSS) als Gegenion.

Das Molekulargewicht der die Polyanionen liefernden Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f.).

Anstelle der für die Bildung der Dispersionen aus Polyalkylendioxythiophenen und Polyanionen erforderlichen freien Polysäuren, kann man auch Gemische aus Alkalisalzen der Polysäuren und entsprechenden Mengen an Monosäuren einsetzen.

Im Falle der Formel (Ib-1) tragen die Polyalkylendioxythiophene positive und negative Ladung in der Struktureinheit.

Die Herstellung der Polyalkylendioxythiophene ist beispielsweise in EP-A 0 440 957 (= US-A 5 300 575) beschrieben. Die Polyalkylendioxythiophene werden durch oxidative Polymerisation hergestellt. Dadurch erhalten sie positive Ladungen, die in den Formeln nicht dargestellt sind, da ihre Zahl und ihre Position nicht einwandfrei feststellbar sind.

Vorteil des erfindungsgemäßen Verfahrens ist, daß offene, elektrisch leitfähige Strukturen in vergleichbarer Qualität wie die bekannten Kupfer-Leiterbahnen auf Platinen hergestellt werden können, aber in wenigen, einfach durchführbaren Verfahrensschritten. Zur Herstellung genügt ein Tintenstrahldrucker mit entsprechend präparierter Drucker-Patrone und ein Computer zur Ansteuerung des Druckers. Die gewünschte Leiterbahnstruktur kann am Bildschirm des Computers entworfen und sofort auf ein geeignetes Substrat ausgedruckt werden.

Das wasserdispergierbare Polyalkylendioxythiophen ist nicht wasserlöslich und bildet eine langzeitstabile, leitfähige Struktur auch unter Normalbedingungen.

### Figuren und Beispiele

Die Abbildungen zeigen:
- Fig. 1: Mit Poly-(3,4-ethylendioxy-thiophen)(PEDT) und Polystryrolsulfonat (PSS) auf Papier gedruckte Bayer-Kreuze.
- Fig. 2: Mit PEDT/PSS auf Papier gedrucktes Leiterbahnschema.
- Fig. 3: Mit PEDT/PSS auf Polyethylenterephtalat (PET)-Folie gedrucktes Leiterbahnschema.

### Beispiel 1

### Herstellung der 3,4-Polyethylendioxythiophen-Dispersion

20 g freie Polystyrolsulfonsäure (Mn ca. 40 000), 21,4 g Kaliumperoxodisulfat und 50 mg Eisen(III)-sulfat wurden unter Rühren in 2 000 ml Wasser vorgelegt. Unter Rühren wurden 8,0 g 3,4-Ethylendioxythiophen zugegeben. Die Dispersion wurde 24 h bei Raumtemperatur gerührt. Anschließend wurden 100 g Anionenaustauscher (Handelsprodukt Bayer AG Lewatit MP 62) und 100 g Kationenaustauscher (Handelsprodukt Bayer AG Lewatit S 100), beide wasserfeucht, zugegeben und 8 Stunden gerührt.

Die Ionenenaustauscher wurden durch Filtration über ein Polyacrylnitrilgewebe mit 50 µm Porengröße entfernt. Es entstand eine gebrauchsfertige Dispersion von 3,4-Polyethylendioxythiophen (PEDT) mit Polystryrolsulfonat (PSS) als Gegenanion (siehe II) mit einem Feststoffgehalt von ca. 1,2 Gew.-%.

Die Dispersion ließ sich leicht durch ein 0,45 µm Filter filtrieren und wurde nach der Filtration zur Herstellung der Farben für den Tintestrahldrucker verwendet.

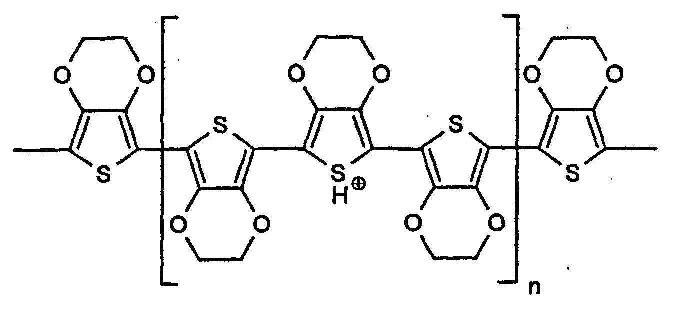

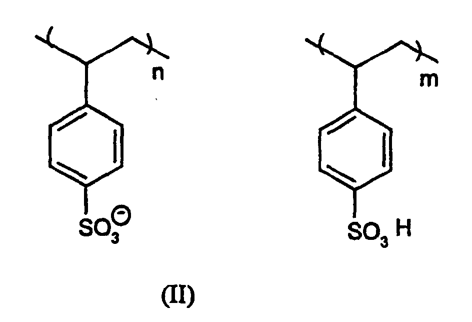

### Beispiel 2

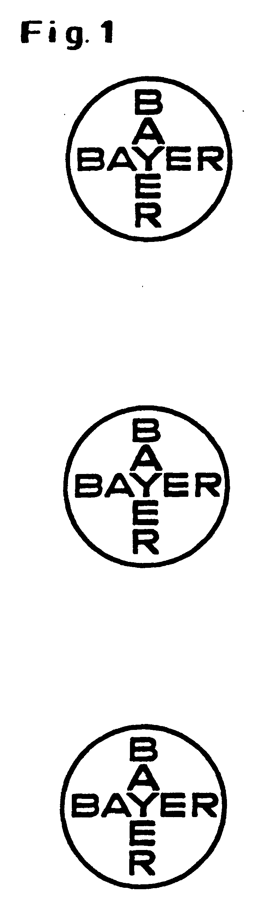

Die wässrige Dispersion des PEDT/PSS gemäß (II) aus Beispiel 1 wurde in eine leere Tintenstrahl-Drucker-Patrone zum HP-Desk-Jet PLUS (Fa. Hewlett-Packard) Tintenstrahldrucker gefüllt. Die nach dem Aufschneiden gut gereinigte Patrone wurde nach der Befüllung mit der PEDT/PSS-Dispersion gemäß (II) wieder mit einem Polyethylen-Schmelzkleber der Fa. Henkel dicht verschlossen. Eine so aufbereitete Tintenstrahl-Drucker-Patrone wurde in den Tintenstrahldrucker HP-Desk-Jet PLUS eingesetzt und diente als Reservoir der Druckflüssigkeit für das Aufbringen der PEDT/PSS-Dispersion nach Ansteuerung des Druckers durch einen Computer. Mit Hilfe eines herkömmlichen Software-Programms wurde ein zu druckendes Muster auf dem Computer entworfen. Gewählt wurde eine Abbildung aus drei untereinanderstehenden Bayer-Kreuzen (Fig. 1). Diese Abbildung wurde computergesteuert auf Papier gedruckt. Man erhielt die drei untereinanderstehenden Bayer-Kreuze aus leitfähigem PEDT/PSS, das eine blaue Eigenfärbung aufwies, auf Papier gedruckt.

### Beispiel 3

Es wurde analog zu Beispiel 2 vorgegangen und nur anstelle des Papiers eine 0,1 mm dicke Polyethylenterephtalat (PET)-Folie mit den Bayer-Kreuzen bedruckt.

### Beispiel 4

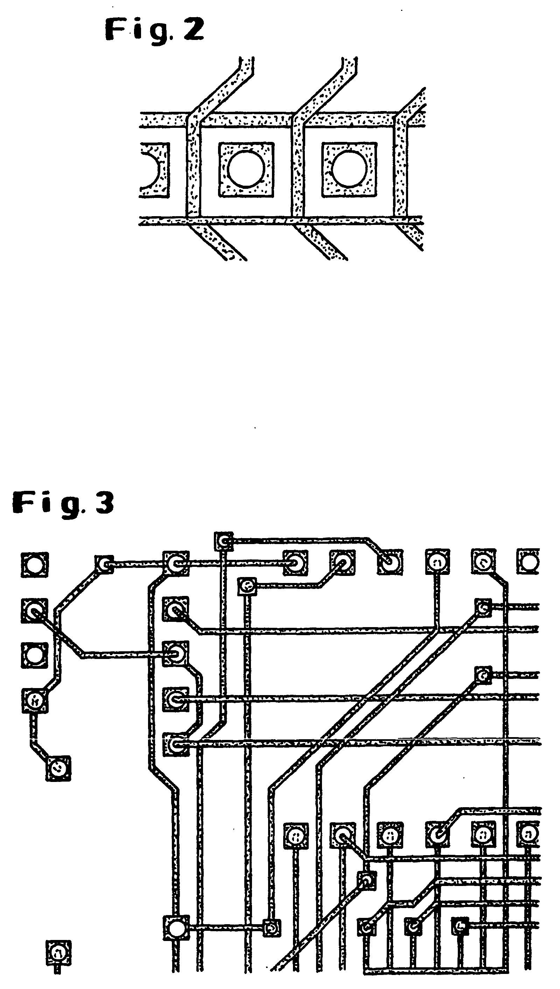

Es wurde analog zu Beispiel 2 vorgegangen, außer daß als Muster mit dem Layout-Software-Programm EAGLE ein Ausschnitt für eine Platine entworfen wurde (Fig. 2).

Dieses Leiterbahnmuster wurde wie unter Beispiel 3 auf Papier mit PEDT/PSS gedruckt.

### Beispiel 5

Analog zu Beispielen 4 wurde das Leiterbahnschema aus Fig. 3 auf eine 0,1 mm dicke PET-Folie gedruckt. Mit Hilfe eines Durchgangsprüfers wurde die elektrische Leitfähigkeit der abgedruckten Leiterbahnen nachgewiesen.

## Patentansprüche

1. Verfahren zur Herstellung von offenen elektrisch leitfähigen Strukturen auf Substraten, **dadurch gekennzeichnet, daß** die leitfähigen Strukturen mit einem Tintenstrahldrucker oder X, Y-Plotter, in deren Patrone sich eine wässrige Dispersion von Polyalkylendioxythiophenen mit einem geeigneten Polyanion als Gegenanion befindet, auf Substrate gedruckt werden.

2. Verfahren nach Anspruch 1, **dadurch gekennzeichnet daß**, die Polyalkylendioxythiophenen kationisch geladenen sind und aus Struktureinheiten der Formel (I) 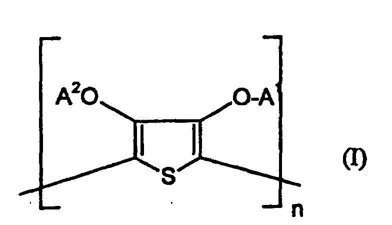 aufgebaut sind, in der
A¹ und A² unabhängig voneinander für gegebenenfalls substituiertes (C₁-C₄)-Alkyl stehen oder zusammen gegebenenfalls substituiertes (C₁-C₄)-Alkylen bilden, und
n für eine ganze Zahl von 2 bis 10.000 vorzugsweise 5 bis 5 000 steht,
in Gegenwart von Polyanionen.

3. Verfahren nach Anspruch 1 oder 2, **dadurch gekennzeichnet daß**, die kationischen Polyalkylendioxythiophene aus Struktureinheiten der Formel (Ia) oder (Ib) aufgebaut sind, 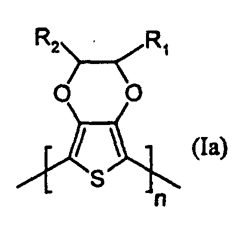 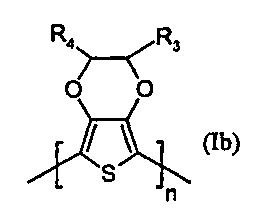 worin
R₁ und R₂ unabhängig voneinander für Wasserstoff, gegebenenfalls substituiertes (C₁- C₁₈)-Alkyl, vorzugsweise (C₁₋C₁₀)-, insbesondere (C₁-C₆)-Alkyl, (C₂-C₁₂)-Alkenyl, vorzugsweise (C₂-C₈)-Alkenyl, (C₃-C₇)-Cycloalkyl, vorzugsweise Cyclopentyl, Cyclohexyl, (C₇-C₁₅)-Aralkyl, vorzugsweise Phenyl-(C₁-C₄)-alkyl, (C₆-C₁₀)-Aryl, vorzugsweise Phenyl, Naphthyl, (C₁-C₁₈)-Alkyloxy, vorzugsweise (C₁-C₁₀)-Alkyloxy, beispielsweise Methoxy, Ethoxy, n- oder iso-Propoxy, oder (C₂-C₁₈)-Alkyloxyester steht und
R₃, R₄ unabhängig voneinander für Wasserstoff, aber nicht beide gleichzeitig, mit mindestens einer Sulfonatgruppe substituiertes (C₁-C₁₈)-Alkyl, vorzugsweise (C₁-C₁₀)-, insbesondere (C₁-C₆)-Alkyl, (C₂-C₁₂)-Alkenyl, vorzugsweise (C₂-C₈)-Alkenyl, (C₃-C₇)-Cycloalkyl, vorzugsweise Cyclopentyl, Cyclohexyl, (C₇-C₁₅)-Aralkyl, vorzugweise Phenyl-(C₁-C₄)-alkyl, (C₆-C₁₀)-Aryl, vorzugweise Phenyl, Naphthyl, (C₁-C₁₈)-Alkyloxy, vorzugweise (C₁-C₁₀)-Alkyloxy, beispielsweise Methoxy, Ethoxy, n- oder iso-Propoxy oder (C₂-C₁₈)-Alkyloxyester steht und
n für eine Zahl von 2 bis 10 000, vorzugsweise 5 bis 5 000 steht.

4. Verfahren nach Anspruch 1 oder 2, **dadurch gekennzeichnet daß**, die kationischen Polyalkylendioxythiophene aus Struktureinheiten der Formel (Ia-1) und/oder (Ib-1) 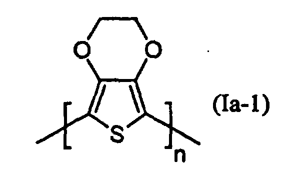 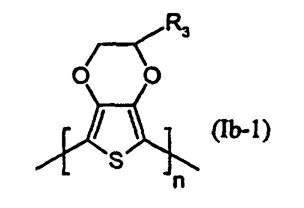 worin
R₃ die obengenannte Bedeutung hat und
n für eine ganze Zahl von 2 bis 10 000, vorzugsweise 5 bis 5 000 steht und als
Polyanionen die Anionen von polymeren Carbonsäuren und/oder polymere Sulfonsäuren dienen.

## Claims

1. Process for preparing open electrically conductive structures on substrates, **characterized in that** the conductive structures are printed onto substrates using an ink-jet printer or X,Y plotter in the cartridge of which there is an aqueous dispersion of polyalkylenedioxythiophenes having a suitable polyanion as gegenanion.

2. Process according to Claim 1, **characterized in that** the polyalkylenedioxythiophenes have been cationically charged and are composed of structural units of the formula (I) 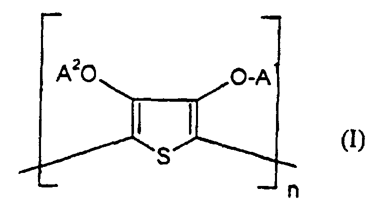 in which
A¹ and A², independently of one another, represent substituted or unsubstituted C₁-C₄-alkyl, or together form a substituted or unsubstituted C₁-C₄-alkylene group, and
n represents an integer from 2 to 10,000, preferably from 5 to 5000,
in the presence of polyanions.

3. Process according to Claim 1 or 2, **characterized in that** the cationic polyalkylenedioxythiophenes are composed of structural units of the formula (Ia) or (Ib), 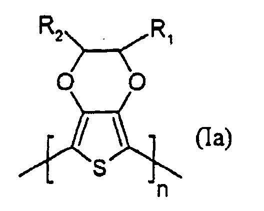 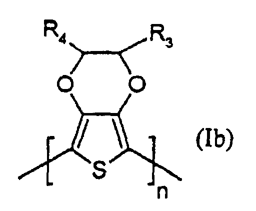 where
R₁ and R₂, independently of one another, represent hydrogen, substituted or unsubstituted C₁-C₁₈-alkyl, preferably C₁-C₁₀-alkyl, in particular C₁-C₆-alkyl, C₂-C₁₂-alkenyl, preferably C₂-C₈-alkenyl, C₃-C₇-cycloalkyl, preferably cyclopentyl or cyclohexyl, C₇-C₁₅-aralkyl, preferably phenyl-C₁-C₄-alkyl, C₆-C₁₀-aryl, preferably phenyl or naphthyl, C₁-C₁₈-alkyloxy, preferably C₁-C₁₀-alkyloxy, such as methoxy, ethoxy, n-propoxy or isopropoxy, or C₂-C₁₈-alkyloxy esters, and
R₃ and R₄, independently of one another, represent hydrogen, but not both simultaneously, or at least singly sulphonate-substituted C₁-C₁₈-alkyl, preferably C₁-C₁₀-alkyl, in particular C₁-C₆-alkyl, C₂-C₁₂-alkenyl, preferably C₂-C₈-alkenyl, C₃-C₇-cycloalkyl, preferably cyclopentyl or cyclohexyl, C₇-C₁₅-aralkyl, preferably phenyl-C₁-C₄-alkyl, C₆-C₁₀-aryl, preferably phenyl or naphthyl, C₁-C₁₈-alkyloxy, preferably C₁-C₁₀-alkyloxy, such as methoxy, ethoxy, n-propoxy or isopropoxy, or C₂-C₁₈-alkyloxy esters, and
n represents a number from 2 to 10,000, preferably from 5 to 5000.

4. Process according to Claim 1 or 2, **characterized in that** the cationic polyalkylenedioxythiophenes are composed of structural units of the formula (Ia-1) and/or (Ib-1) 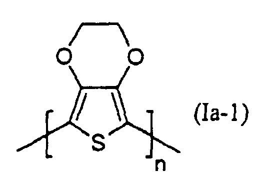 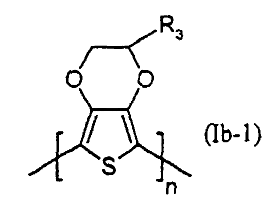 where
R₃ is as defined above, and
n represents an integer from 2 to 10,000, preferably from 5 to 5000,
and the polyanions comprise anions of polymeric carboxylic acids and/or of polymeric sulphonic acids.

## Revendications

1. Procédé pour imprimer des structures ouvertes électriquement conductrices sur des supports, **caractérisé en ce que** les structures conductrices sont imprimées sur des supports au moyen d'une imprimante à jet d'encre ou au moyen d'un traceur X, Y, dont la cartouche contient une dispersion aqueuse de polyalkylènedioxythiophène qui comporte un polyanion qui convient comme contre-anion.

2. Procédé selon la revendication 1, **caractérisé en ce que** les polyalkylènedioxythiophènes sont chargés cationiquement et sont composés d'unités structurelles de la formule (I): 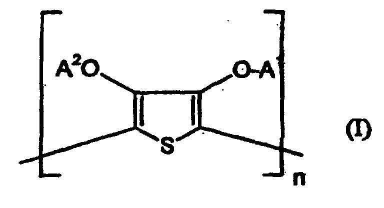 dans laquelle:
A¹ et A² représentent indépendamment l'un de l'autre des alkyles en C₁ à C₄ éventuellement substitués ou forment ensemble des alkyles en C₁ à C₄ éventuellement substitués et
n représente un nombre entier compris entre 2 et 10 000, de préférence entre 5 et 5 000,
en présence de polyanions.

3. Procédé selon la revendication 1 ou la revendication 2, **caractérisé en ce que** les polyalkylènedioxythiophènes cationiques préférés sont constitués d'unités structurelles de formule (Ia) ou de formule (Ib) 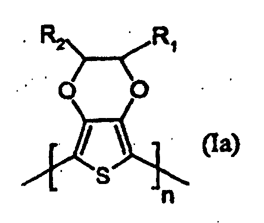 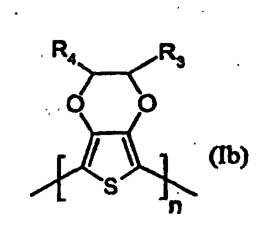 dans lesquelles:
R₁ et R₂ représentent indépendamment l'un de l'autre l'hydrogène, un alkyle en C₁ à C₁₈, de préférence un alkyle en C₁ à C₁₀ et en particulier en C₁ à C₆, un alcényle en C₂ à C₁₂ et de préférence un alcényle en C₂ à C₈, un cycloalkyle en C₃ à C₇ et de préférence un cyclopentyle ou un cyclohexyle, un aralkyle en C₇ à C₁₅ et de préférence un phényl(alkyle en C₁ à C₄), un aryle en C₆ à C₁₀ et de préférence le phényle ou le naphtyle, un alkyloxy en C₁ à C₁₈ et de préférence un alkyloxy en C₁ à C₁₀, par exemple le méthoxy, l'éthoxy, le n-propoxy ou l'isopropoxy, ou un alkyloxy en C₂ à C₁₈, éventuellement substitués et
R₃ à R₄ représentent indépendamment l'un de l'autre l'hydrogène, mais pas tous deux simultanément, un alkyle en C₁ à C₁₈, de préférence un alkyle en C₁ à C₁₀ et en particulier un alkyle en C₁ à C₆, un alcényle en C₂ à C₁₂ et de préférence un alcényle en C₂ à C₈, un cycloalkyle en C₃ à C₇ et de préférence le cyclopentyle ou le cyclohexyle, un aralkyle en C₇ à C₁₅ et de préférence un phényl(alkyle en C₁ à C₄), un aryle en C₆ à C₁₀ et de préférence le phényle ou le naphtyle, un alkyloxy en C₁ à C₁₈ et de préférence un alkyloxy en C₁ à C₁₀, par exemple le méthoxy, l'éthoxy, le n-propoxy ou l'isopropoxy, ou un alkyloxyester en C₂ à C₁₈, substitués avec au moins un groupe sulfonate et
n représente un nombre compris entre 2 à 10 000 et de préférence entre 5 et 5 000.

4. Procédé selon la revendication 1 ou la revendication 2, **caractérisé en ce que** les polyalkylènedioxythiophènes cationiques sont constitués d'unités structurelles de formule (Ia-1) et/ou de formule (Ib-1) 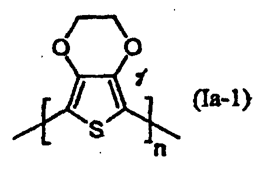 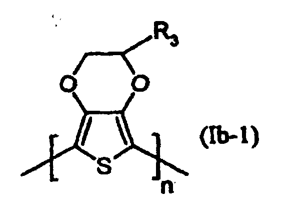 dans lesquelles:
R₃ a la signification donné plus haut et
n représente un nombre entier compris entre 2 et 10 000 et de préférence entre 5 et 5 000,
les anions d'acides carboxyliques polymères et/ou d'acide sulfonique polymère servant de polyanions.
